# EUROPÄISCHE PATENTSCHRIFT

(11) **EP 0 715 151 B1**
(45) Veröffentlichungstag und Bekanntmachung des Hinweises auf die Patenterteilung: **16.04.1997**
(21) Anmeldenummer: 95114699.2
(22) Anmeldetag: 19.09.1995
(51) Int. Cl.: G01D 5/14, G01D 5/16, H03M 1/24

(54) **Massverkörperung und Verfahren zur Herstellung dieser Massverkörperung**
Measuring scale and method for fabricating the same
Echelle de mesure et son procédé de fabrication

(30) Priorität: 29.11.1994 DE 4442371
(43) Veröffentlichungstag der Anmeldung: 05.06.1996
(73) Patentinhaber: Dr. Johannes Heidenhain GmbH, D-83292 Traunreut (DE)
(72) Erfinder: Spies, Alfons, D-83358 Seebruck (DE)

(56) Entgegenhaltungen:
- GB-A- 2 016 144
- US-A- 4 987 415

## Beschreibung

Die Erfindung betrifft eine Maßverkörperung gemäß dem Oberbegriff des Anspruches 1 sowie ein Verfahren zur Herstellung einer Maßverkörperung gemäß den Oberbegriffen der Ansprüche 18 und 19.

Derartige Maßverkörperungen werden insbesondere in Positionsmeßeinrichtungen bei Bearbeitungsmaschinen zur Messung der Relativlage eines Werkzeuges bezüglich eines zu bearbeitenden Werkstückes sowie bei Koordinatenmeßmaschinen zur Ermittlung von Lage und Abmessungen von Prüfobjekten eingesetzt.

Weiterhin betrifft die Erfindung eine Positionsmeßeinrichtung, in der eine derartige Maßverkörperung verwendet wird.

Aus der EP-A2 0 069 392 ist eine Maßverkörperung bekannt, bei der auf einem Träger eine Schicht magnetisierbaren Materials aufgebracht ist. In diese Schicht sind mehrere nebeneinander liegende Magnetspuren eingeschrieben. Jede Magnetspur besteht aus aufeinanderfolgenden Bereichen entgegengesetzter Magnetisierung. Der periodische Flußwechsel wird von einem magnetfeldempfindlichen Abtastelement erfaßt und positionsabhängige Abtastsignale erzeugt.

Die Magnetisierung einer derartigen Maßverkörperung ist sehr aufwendig.

Eine weitere Maßverkörperung ist in der DE-B-1 281 549 beschrieben. Die Maßverkörperung besteht aus einem nichtmagnetischen Körper, in den Bohrungen zur Aufnahme von einzelnen Stabmagneten eingebracht sind. Die Stabmagnete sind abwechselnd gegensinnig magnetisiert.

Die Herstellung dieser Maßverkörperung ist äußerst aufwendig, da jede Bohrung individuell eingebracht und die Stabmagnete einzeln darin positioniert werden müssen.

In der GB-A 2 016 144 ist eine Maßverkörperung offenbart, bei der ein Träger ganzflächig mit magnetischem Material beschichtet wird und danach die Magnetspuren eingeschrieben werden. Weiterhin sind Ausführungen erläutert, bei denen einzelne Magnetelemente auf einem Träger aufgebracht sind.

Auch bei diesen Maßverkörperungen ist die Magnetisierung aufwendig.

Aus der US-PS 3,961,214 - von der diese Erfindung ausgeht - ist eine Maßverkörperung bekannt, die aus einem Körper mit einzelnen Magnetelementen besteht. Alle Magnetelemente sind gleichsinnig axial magnetisiert. Die Magnetelemente sind in Meßrichtung voneinander beabstandet angeordnet.

Bei dieser Maßverkörperung ist besonders nachteilig, daß an dessen Oberfläche kein nullsymmetrisches Magnetfeld vorliegt.

Der Erfindung liegt die Aufgabe zugrunde, eine Maßverkörperung und eine Positionsmeßeinrichtung mit einer derartigen Maßverkörperung zu schaffen, die einfach und kostengünstig herstellbar ist. An der Oberfläche der Maßverkörperung soll ein zumindest annähernd nullsymmetrisches Magnetfeld vorliegen.

Diese Aufgabe wird erfindungsgemäß durch die Merkmale der Ansprüche 1, 18, 19 sowie 20 gelöst.

Die mit der Erfindung erzielten Vorteile bestehen insbesondere darin, daß die Maßverkörperung mit einfachen Fertigungsverfahren hergestellt werden kann, und daß insbesondere eine einfache Magnetisierung ermöglicht wird.

Vorteilhafte Ausbildungen der Erfindung entnimmt man den abhängigen Ansprüchen.

Ausführungsbeispiele der Erfindung werden anhand der Zeichnungen näher erläutert.

Es zeigt
- Figur 1: eine perspektivische Ansicht eines axial magnetisierten Grundköpers,
- Figur 2: einen zirkular magnetisierten Grundkörper,
- Figur 3: einen radial magnetisierten Grundkörper,
- Figur 4: eine perspektivische Ansicht einer erfindungsgemäß zweiteiligen axial magnetisierten Teilscheibe,
- Figur 5: eine weitere zweiteilige Teilscheibe,
- Figur 6: eine Teilscheibe mit Funktionselementen,
- Figur 7: ein Signaldiagramm, welches bei der Abtastung des Grundkörpers gemäß Figur 1 entsteht,
- Figur 8: ein Signaldiagramm, welches bei der Abtastung der Teilscheibe gemäß Figur 4 entsteht,
- Figur 9: einen linearen Grundkörper und
- Figur 10: eine zweiteilige lineare Maßverkörperung gemäß der Erfindung.

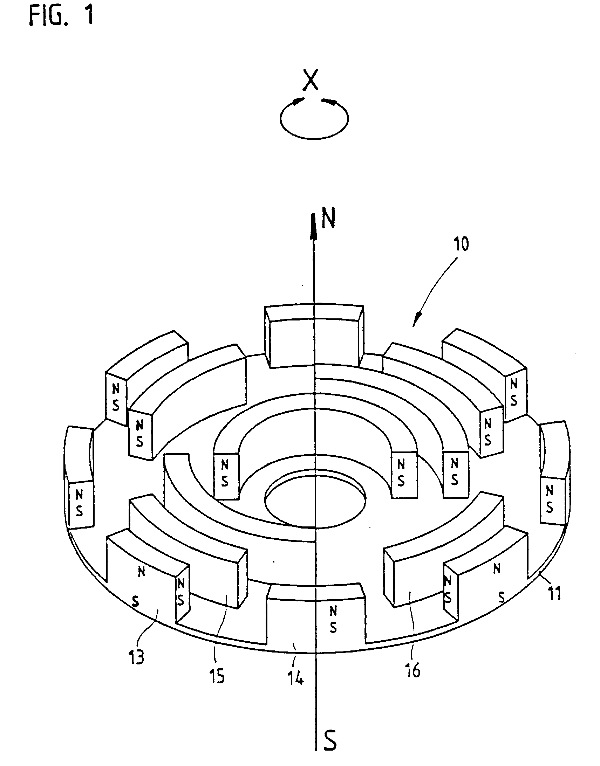

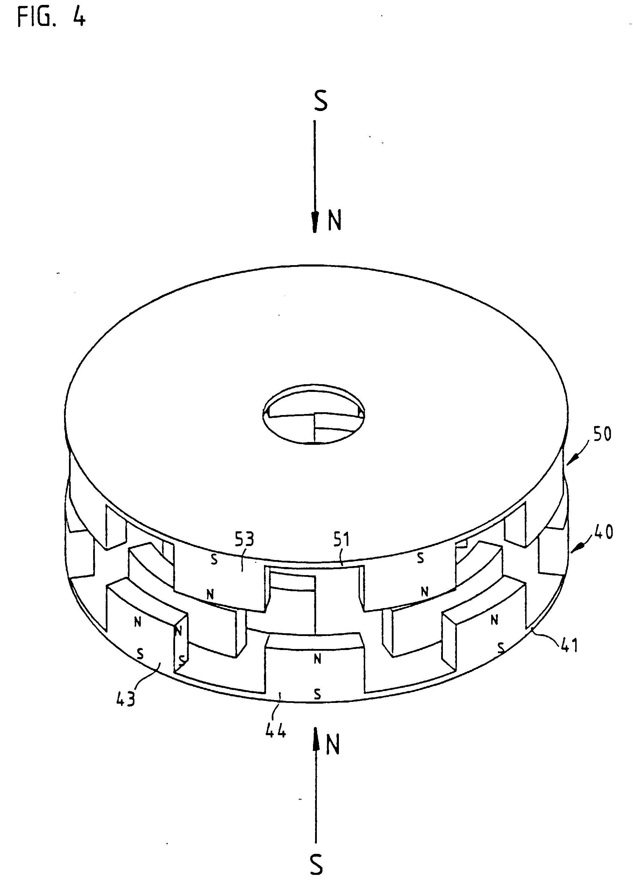

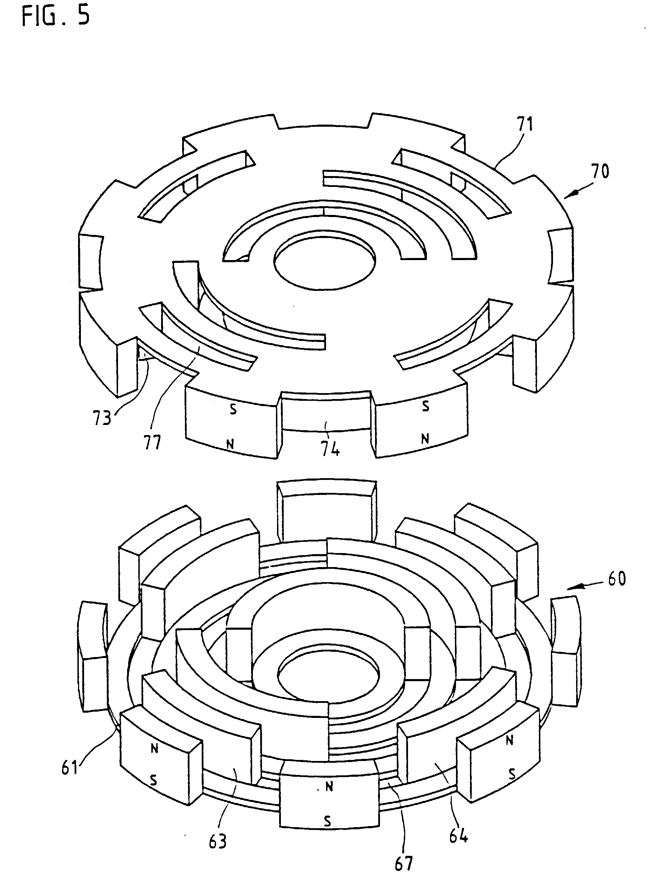

In den nachfolgend beschriebenen Figuren 1 bis 3 werden Grundkörper 10, 20, 30 erläutert, von denen erfindungsgemäß jeweils zwei zu einer Teilscheibe zusammengefügt werden. Dieses Zusammenfügen wird anhand der Figuren 4 und 5 näher angegeben.

In Figur 1 ist ein Grundkörper 10 einer Teilscheibe einer Winkelmeßeinrichtung dargestellt. Der Grundkörper 10 besteht aus einem dünnen scheibenartigen Träger 11, auf dem voneinander beabstandete Magnetelemente 13, 14, 15, 16 aus hartmagnetischem Material vorgesehen sind. Der Träger 11 besteht aus unmagnetischem oder weichmagnetischem Material. Die Magnetelemente 13, 14 sind in einer Spur in Meßrichtung X voneinander beabstandet angeordnet. Der Raum zwischen den Magnetelementen 13, 14 ist materialfrei und somit unmagnetisch. Parallel zu der Spur mit den Magnetelementen 13, 14 sind weitere Spuren mit voneinander beabstandeten Magnetelementen 15, 16 vorhanden. Die Magnetelemente 13, 14, 15, 16 bilden somit einen Code zur absoluten Positionsbestimmung innerhalb einer Umdrehung des Grundkörpers.

Alle Magnetelemente 13, 14, 15, 16 sind axial in der gleichen Richtung magnetisiert, wie der von S nach N weisende Pfeil verdeutlichen soll. Der Vorteil dieses Aufbaus besteht darin, daß alle Magnetelemente 13, 14, 15, 16 aller Spuren gleichzeitig in einem homogenen Feld magnetisiert werden können, ohne daß eine exakte Positionierung zwischen dem Grundkörper 10 und der Magnetisiereinrichtung erforderlich ist. Die Magnetisierung aller Magnetelemente 13, 14, 15, 16 erfolgt durch einen einzigen Verfahrensschritt besonders vorteilhaft mittels einer einzigen Spulenanordnung.

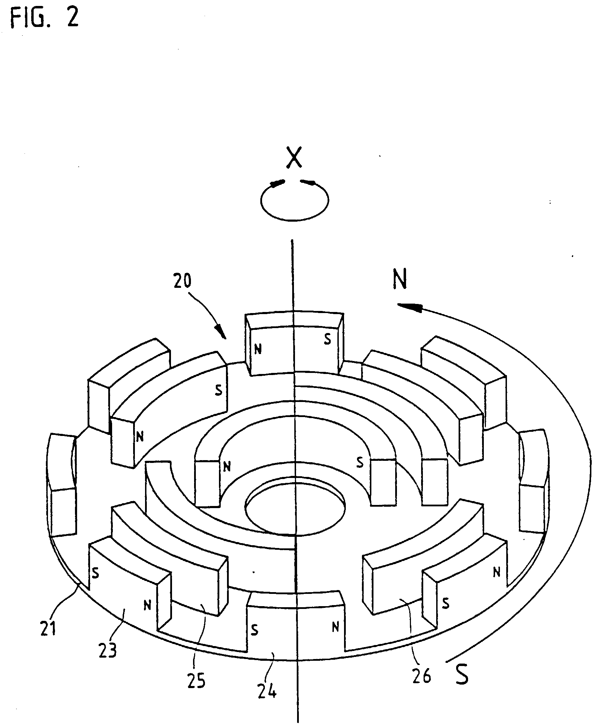

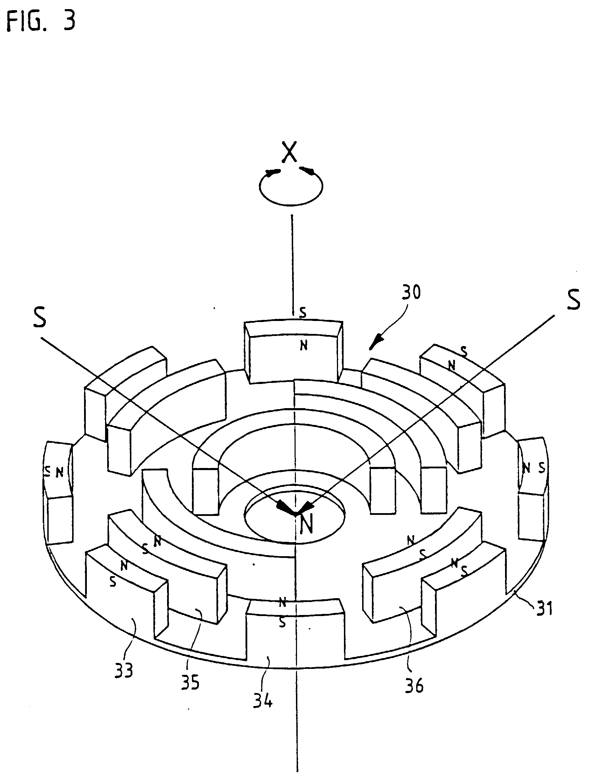

In Figur 2 und 3 ist jeweils ein weiterer Grundkörper 20, 30 dargestellt. Der Aufbau entspricht dem Grundkörper 10 gemäß Figur 1. Die Magnetelemente 23 bis 26 und 33 bis 36 sind auf einem Träger 21 bzw. 31 aufgebracht.

Alle Magnetelemente 23, 24, 25, 26 des Grundkörpers 20 sind beim Ausführungsbeispiel gemäß Figur 2 parallel zur Meßrichtung X und in eine gemeinsame Richtung weisend von S nach N zirkular magnetisiert.

Alle Magnetelemente 33, 34, 35, 36 des Grundkörpers 30 sind bei einem weiteren Ausführungsbeispiel gemäß Figur 3 radial in eine gemeinsame Richtung weisend magnetisiert.

Die Richtung des Magnetfeldes jedes Magnetelementes 13 bis 16 sowie 33 bis 36 ist senkrecht zur Meßrichtung X gerichtet, wogegen die Richtung des Magnetfeldes jedes Magnetelementes 23 bis 26 parallel zur Meßrichtung X ist.

Der Grundkörper 10, 20, 30 wird besonders vorteilhaft im Spritz-, Spritzgieß-, Präge-, Press- oder Sinterverfahren hergestellt. Beim Spritzgießverfahren bestehen die Magnetelemente 13 bis 16, 23 bis 26 und 33 bis 36 aus kunststoffgebundenen Dauermagneten, wodurch eine kostengünstige Massenproduktion ermöglicht wird. Dabei ist eine isotrope oder eine anisotrope Fertigung möglich. Isotrop bedeutet dabei, daß die Elementarmagnete nach dem Einspritzen in einem ungeordneten Zustand vorliegen. Während des Spritzvorganges wird kein äußeres Magnetfeld angelegt. Die Magnetisierung der Magnetelemente 13 bis 16, 23 bis 26, 33 bis 36 erfolgt erst nach beendetem Spritzgießverfahren. Beim anisotropen Verfahren wird während des Einspritzvorganges ein äußeres Magnetfeld angelegt, wodurch sich die Elementarmagnete beim Spritzen vorab orientieren. Die hierbei zu erzielenden magnetischen Eigenschaften sind erheblich besser als bei einer isotropen Herstellung, da sich durch diesen Effekt die Ferritpartikel mit ihrer magnetischen Vorzugsachse leicht parallel zur gewünschten Orientierung ausrichten.

Für die Realisierung von äußeren oder inneren Magnetfeldern zur Magnetisierung werden Permanentmagnete oder Spulen eingesetzt.

Bei den Ausführungsbeispielen gemäß Figur 1 bis 3 sind die Magnetelemente 13 bis 16, 23 bis 26, 33 bis 26 auf den nichtmagnetischen Träger 11, 21, 31 aufgespritzt. Wird für den Träger 11, 21, 31 auch Kunststoff gewählt, kann der Grundkörper 10, 20, 30 auch im Zweikomponenten-Spritzverfahren gefertigt werden, indem in eine Form zwei verschiedene Materialien eingespritzt werden.

Die Herstellung im Spritzgießverfahren hat den besonderen Vorteil, daß Funktionselemente in Form von Naben, Achsen oder Zahnrädern an den Grundkörper direkt einstückig angespritzt, oder daß derartige Funktionselemente eingespritzt oder eingedrückt oder eingelegt werden können.

Vereinfacht wird die Herstellung des Grundkörpers 10, 20, 30, wenn der Träger aus dem gleichen hartmagnetischen Material wie die Magnetelemente bestehen. In die Form wird beim Spritzgießverfahren nur ein einziges Material eingespritzt. In Figur 4 sind zwei derartige Grundkörper 40, 50 dargestellt. Da der Träger 41, 51 dünn ist im Verhältnis zu der Höhe der Magnetelemente 43, 44, 53, tritt nur eine geringe Beeinflussung des von den Magnetelementen 43, 44, 53 ausgehenden Magnetfeldes auf.

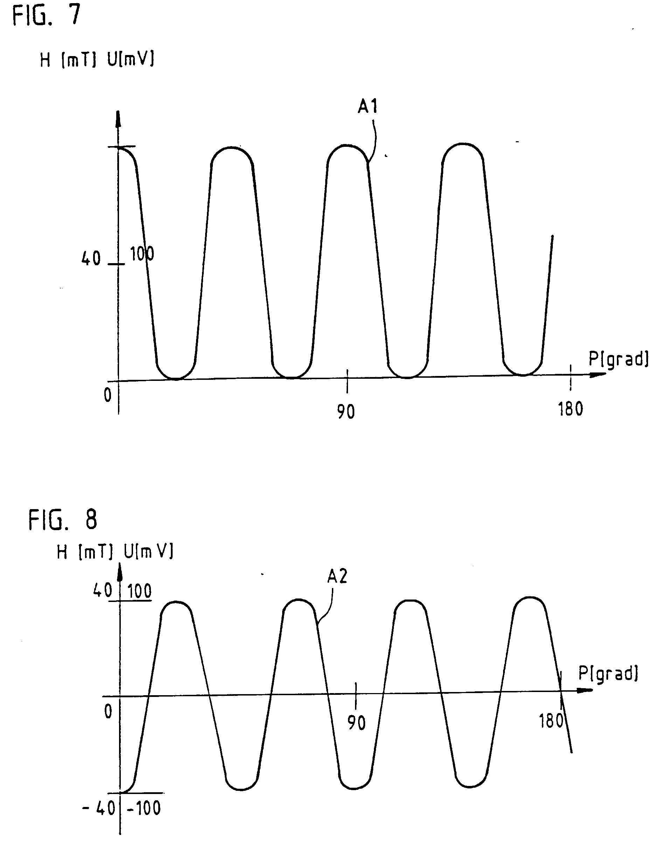

Wird einer der Grundkörper 10, 20, 30, 40, 50 von einem magnetfeldempfindlichen Abtastelement, beispielsweise einem Hallelement abgetastet, indem sich der Grundkörper 10, 20, 30, 40, 50 relativ zum stationären Hallelement in Meßrichtung X bewegt, liefert das Hallelement ein positionsabhängiges Abtastsignal A1, wie es in Figur 7 dargestellt ist. Durch Triggerung dieses analogen Abtastsignales Al wird in bekannter Weise ein binäres Signal gebildet. Aufgrund des nicht nullsymetrischen Magnetfeldes an der Oberfläche eines Grundkörpers 10, 20, 30, 40, 50, ist auch das Abtastsignal Al nich nullsymmetrisch.

In den Signaldiagrammen Figur 7 und Figur 8 ist die von der Position P in Grad abhängige magnetische Feldstärke H in mT am Ort des Hallelementes und die proportional dazu am Hallelement anstehende Signalspannung U in mV aufgetragen.

Zur Bildung des binären Signals ist es vorteilhaft, wenn das analoge Abtastsignal A2 nullsymmetrisch ist, wie in Figur 8 gezeigt. Dieses Abtastsignal A2 wird durch Abtastung der in den Figuren 4 bis 6 gezeigten erfindungsgemäß ausgebildeten Teilscheiben erzielt.

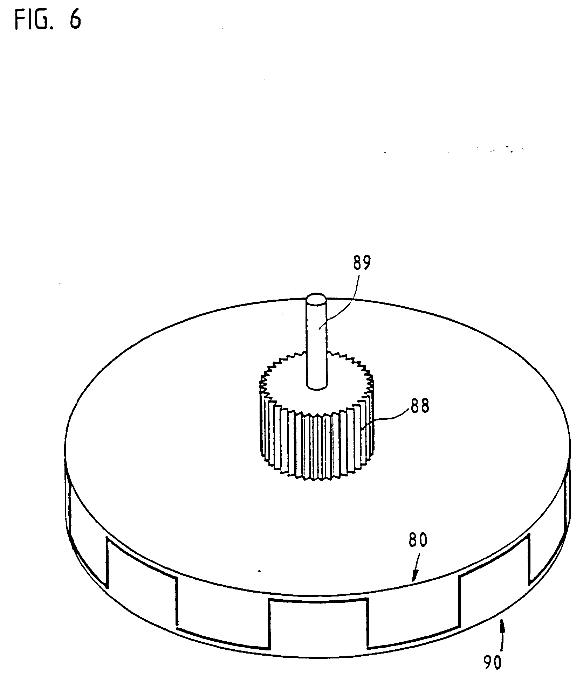

Die Teilscheibe nach Figur 4 besteht aus zwei identischen Grundkörpern 40, 50, wie sie bereits beschrieben wurden. Es können zwei Grundkörper 10, 20, 30 gemäß den Figuren 1, 2 oder 3 Verwendung finden. Die zwei Grundkörper 40, 50 werden so zusammengefügt, daß in den Zwischenraum zweier in Meßrichtung X beabstandet angeordneter Magnetelemente 43 und 44 des unteren Grundkörpers 40 ein erhabenes Magnetelement 53 des oberen Grundkörpers 50 paßgenau eingreift. Figur 4 zeigt den Zustand des Zusammenfügens, wogegen in Figur 6 zwei bereits zu einer Teilscheibe zusammengefügte Grundkörper 80, 90 dargestellt sind. Da die beiden Grundkörper 40, 50 bei der Herstellung gleichsinnig magnetisiert wurden und ein Grundkörper 50 beim Zusammenfügen um 180° gewendet wurde, ergibt sich eine Magnetisierung der Magnetelemente 53 gegensinnig zu den Magnetelementen 43 und 44. Durch diese Maßnahme erhält man eine Teilscheibe mit in Meßrichtung X abwechselnd gegensinnig magnetisierten Bereichen in Form von Magnetelementen 43, 53, 44. Um eine gut handhabbare Teilscheibe zu erhalten, werden die beiden Grundkörper 40, 50 miteinander verklebt.

Die Abtastung der Teilscheibe erfolgt vorzugsweise mit einem Abtastelement, welches der freien Oberfläche des Trägers 41 und 51 gegenübersteht. Bestehen die Träger 41 und 51 aus nichtmagnetischem oder nichtmagnetisiertem Material, liegt an dieser Stelle ein nullsymmetrisches magnetisches Wechselfeld in Meßrichtung X vor. Die Nullsymmetrie wird geringfügig gestört, wenn die Träger 41, 51 ebenfalls magnetisiert sind. Um auch hier ein nullsymmetrisches Feld zu erhalten, kann nach dem Zusammenfügen der beiden Grundkörper 40, 50 ein Gegenfeld angelegt werden und die Magnetisierung so geändert werden, daß das Störfeld kompensiert wird.

Eine weitere Möglichkeit wäre, die Träger 41, 51 nach dem Verkleben zu entfernen, z.B. abzufräsen oder abzuschleifen, so daß nur die Magnetelemente 43, 53, 44 stehen bleiben.

Eine besonders vorteilhafte Möglichkeit, um ein nullsymmetrisches Wechselfeld in Meßrichtung X zu erhalten, besteht darin, die dünnen Stege der Träger 41, 51 zu entmagnetisieren. Um die dünnen Stege zu entmagnetisieren genügt ein kleines Gegenfeld. Die Magnetisierung der Magnetelemente 43, 53, 44 wird dabei nur geringfügig geschwächt.

Ein nullsymmetrisches Wechselfeld am Ort des Abtastelementes kann auch erzielt werden, wenn der dem Abtastelement gegenüberstehende Grundkörper 40 schwächer magnetisiert ist, als der Grundkörper 50, welcher vom Abtastelement weiter entfernt angeordnet ist. Eine weitere Möglichkeit wäre, die beiden Grundkörper 40, 50 geometrisch unterschiedlich auszubilden.

In Figur 5 ist eine Teilscheibe, bestehend aus zwei Grundkörpern 60, 70 während des Fügevorganges dargestellt. Die Magnetisierung ist entsprechend den bereits erläuterten Beispielen ausgeführt. Zur Erzeugung eines nullsymmetrischen Magnetfeldes an den beiden ebenen Oberflächen der Teilscheibe sind in den Grundkörpern 60 bzw. 70 durchgehende Aussparungen 67, 68 bzw. 77, 78 vorgesehen, in die jeweils die erhabenen Endbereiche der Magnetelemente 73, 74 bzw. 63, 64 des anderen Grundkörpers 70 bzw. 60 paßgenau eingreifen.

Figur 6 zeigt eine Teilscheibe aus zwei erfindungsgemäß zusammengefügten Grundkörpern 80, 90. Die Grundkörper 80, 90 sind zwei Formteile, die im Spritzgießverfahren aus kunststoffgebundenen Dauermagneten bestehen. An den Grundkörper 80 ist ein Zahnrad 88 angespritzt sowie eine Stahlwelle 89 eingelegt. Derartige Funktionselemente können an einem oder auch an beiden Grundkörpern angespritzt, eingelegt oder eingepreßt sein.

Ein Einsatzgebiet erfindungsgemäß ausgestalteter Teilscheiben sind inkrementale oder absolute Winkelmeßsysteme, insbesondere Multiturn-Codedrehgeber, bei denen mehrere gleichartige Teilscheiben über Untersetzungsgetriebe angetrieben werden und dadurch die Absolutposition einer Antriebswelle über mehrere Umdrehungen gemessen werden kann. Eine erfindungsgemäß ausgestaltete Teilscheibe kann auch bei Antiblockier-Systemen Verwendung finden.

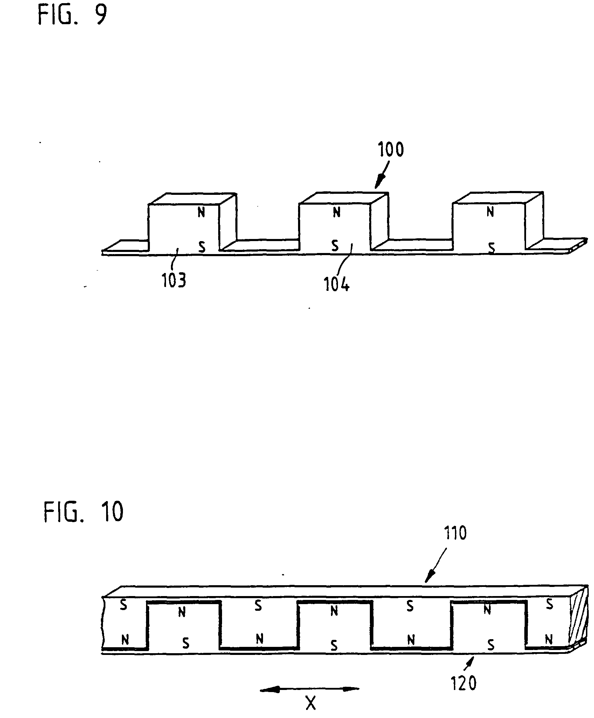

Die Erfindung kann auch bei linearen Maßverkörperungen eingesetzt werden, die bei Linearmeßsystemen Anwendung finden. Ein Beispiel hierzu ist in Figur 10 dargestellt. Gemäß Figur 9 besteht ein linearer Grundkörper 100 aus voneinander beabstandeten Magnetelementen 103 bis 104, die in einer gemeinsamen Richtung gleichsinnig magnetisiert sind.

In Figur 10 ist ein erfindungsgemäß ausgeführter linearer Maßstab dargestellt, der aus zwei geometrisch gleich ausgebildeten und gleich magnetisierten Grundkörpern 110, 120 besteht. Die Magnetisierung der Magnetelemente kann auch hier in Meßrichtung X oder senkrecht dazu erfolgen. Ansonsten sind bei linearen Maßstäben die gleichen bereits bei den Teilscheiben gemäß Figur 1 bis 6 beschriebenen Maßnahmen einsetzbar.

Die Maßverkörperungen können Magnetelemente in einer oder in mehreren Spuren aufweisen und inkremental oder codiert ausgebildet sein, wobei eine Codierung auch in einer einzigen Spur als sogenannter Kettencode möglich ist.

Bei den gezeigten Ausführungen sind die Magnetelemente rechteckförmig gestuft strukturiert, sie können aber auch sinusförmig oder dreieckförmig strukturiert sein.

Besonders vorteilhaft ist es, wenn die Maßverkörperung nur aus zwei Grundkörpern 40, 50, 60, 70, 80, 90, 110, 120 besteht. Es liegt aber auch im Rahmen der Erfindung, daß die Maßverkörperung aus mehr als zwei ineinandergreifenden Grundkörpern besteht. Bei mehrspurigen Maßverkörperungen, wie sie in den Figuren 4 bis 6 gezeigt sind, kann beispielsweise jede Spur aus zwei Grundkörpern bestehen. Bei den dargestellten 4 Spuren wären das 8 Grundkörper, die nach dem erfindungsgemäßen Zusammenfügen eine Maßverkörperung bilden. Auch bei großen oder langen Maßverkörperungen können - bezogen auf die gesamte Meßlänge - mehr als zwei Grundkörper zur Bildung der Maßverkörperung dienen.

## Patentansprüche

1. Maßverkörperung mit in Meßrichtung (X) angeordneten Magnetelementen (43, 44, 53, 63, 64, 73, 74) dadurch gekennzeichnet, daß die Maßverkörperung aus zusammengefügten Grundkörpern (40, 50, 60, 70, 80, 90, 110, 120) besteht, wobei alle Magnetelemente (43, 44, 53, 63, 64, 73, 74) jedes Grundkörpers (40, 50, 60, 70, 80, 90, 110, 120) in einer einzigen gemeinsamen Richtung gleichsinnig magnetisiert sind, und daß die zusammengefügte Maßverkörperung in Meßrichtung (X) abwechselnd ein Magnetelement (43, 44, 53, 63, 64, 73, 74) eines Grundkörpers (40, 60) und eines weiteren Grundkörpers (50, 70) aufweist, wobei das Magnetfeld der Magnetelemente (43, 44, 63, 64) des einen Grundkörpers (40, 60) im zusammengefügten Zustand zu dem Magnetfeld der Magnetelemente (53, 73, 74) des anderen Grundkörpers (50, 70) entgegengesetzt gerichtet ist.

2. Maßverkörperung nach Anspruch 1, dadurch gekennzeichnet, daß die Maßverkörperung aus zwei zusammengefügten Grundkörpern (40, 50, 60, 70, 80, 90, 110, 120) besteht.

3. Maßverkörperung nach Anspruch 1 oder 2, dadurch gekennzeichnet, daß die Grundkörper (40, 50, 60, 70) zumindest annähernd gleiche Abmessungen aufweisen und beim Zusammenfügen in die Lücken der erhabenen Magnetelemente (43, 44, 63, 64) des einen Grundkörpers (40, 60) die erhabenen Magnetelemente (53, 73, 74) des anderen Grundkörpers (50, 70) eingreifen.

4. Maßverkörperung nach einem der Ansprüche 1 bis 3, dadurch gekennzeichnet, daß die Grundkörper (40, 50, 60, 70) durch Kleben zusammengefügt sind.

5. Maßverkörperung nach einem der Ansprüche 1 bis 4, dadurch gekennzeichnet, daß die in Meßrichtung (X) angeordneten Magnetelemente (43, 44, 53, 63, 64, 73, 74) an der Oberfläche der Maßverkörperung ein zumindest annähernd nullsymmetrisches magnetisches Wechselfeld bilden.

6. Maßverkörperung nach Anspruch 5, dadurch gekennzeichnet, daß die Magnetelemente (63, 64, 73, 74) auf einem Träger (61, 71) mit durchgehenden Aussparungen (67, 77) vorgesehen sind, wobei in diese Aussparungen (67, 77) die Magnetelemente (74, 63) des anderen Grundkörpers (70, 60) eingreifen.

7. Maßverkörperung nach Anspruch 5, dadurch gekennzeichnet, daß die Magnetelemente auf einem Träger aus hartmagnetischem Material aufgebracht sind, und daß die dünnen Stege des Trägers zwischen den Magnetelementen entmagnetisiert sind.

8. Maßverkörperung nach einem der Ansprüche 1 bis 7, dadurch gekennzeichnet, daß alle Magnetelemente (13 bis 16, 23 bis 26, 33 bis 36, 43, 44, 53, 63, 64, 73, 74, 103, 104) eines Grundköpers (10, 20, 30, 40, 50, 60, 70, 80, 90, 100, 110, 120) parallel zur Meßrichtung (X) oder senkrecht zur Meßrichtung (X) magnetisiert sind, und daß die Magnetelemente (13 bis 16, 23 bis 26, 33 bis 36, 43, 44, 53, 63, 64, 73, 74, 103, 104) erhaben strukturiert ausgebildet sind.

9. Maßverkörperung nach Anspruch 8, dadurch gekennzeichnet, daß die Magnetelemente (13 bis 16, 23 bis 26, 33 bis 36, 43, 53, 63, 64, 73, 74, 103, 104) rechteckförmig, sinusförmig oder dreieckförmig strukturiert sind.

10. Maßverkörperung nach einem der Ansprüche 1 bis 9, dadurch gekennzeichnet, daß alle Magnetelemente (13 bis 16, 23 bis 26, 33 bis 36) eines Grundkörpers (10, 20, 30) auf einem weichmagnetischen oder nichtmagnetischen Träger (11, 21, 31) erhaben aufgebracht sind.

11. Maßverkörperung nach einem der Ansprüche 1 bis 9, dadurch gekennzeichnet, daß alle Magnetelemente (43, 44, 53, 63, 64, 73, 74) eines Grundkörpers (40, 50, 60, 70) erhaben auf einem Träger (41, 51, 61, 71) aufgebracht sind, wobei die Magnetelemente (43, 44, 53, 63, 64, 73, 74) und der Träger (41, 51, 61, 71) aus dem gleichen Material bestehen und ein einstückiges Formteil bilden.

12. Maßverkörperung nach Anspruch 10 oder Anspruch 11, dadurch gekennzeichnet, daß die Magnetelemente (13 bis 16, 23 bis 26, 33 bis 36, 43, 44, 53, 63, 64, 73, 74, 103, 104) aus kunststoffgebundenen hartmagnetischem Material bestehen.

13. Maßverkörperung nach einem der Ansprüche 1 bis 12, dadurch gekennzeichnet, daß in Meßrichtung (X) voneinander beabstandete Magnetelemente (13 bis 16, 23 bis 26, 33 bis 36, 43, 44, 53, 63, 64, 73, 74, 103, 104) in mehreren Spuren vorgesehen sind, wobei die Magnetelemente (13 bis 16, 23 bis 26, 33 bis 36, 43, 44, 53, 63, 64, 73, 74, 103, 104) der einzelnen Spuren senkrecht zur Meßrichtung (X) betrachtet voneinander beabstandet angeordnet sind.

14. Maßverkörperung nach einem der Ansprüche 1 bis 13, dadurch gekennzeichnet, daß die Maßverkörperung eine Teilscheibe für eine Winkelmeßeinrichtung ist, bei der die Magnetelemente (13 bis 16, 23 bis 26, 33 bis 36, 43, 44, 53, 63, 64, 73, 74) radial oder axial oder zirkular magnetisiert sind.

15. Maßverkörperung nach einem der Ansprüche 1 bis 14, dadurch gekennzeichnet, daß zumindest ein Grundkörper (80) ein einstückiges Formteil ist, an dem zumindest ein Funktionselement (88) angeformt ist.

16. Maßverkörperung nach einem der Ansprüche 1 bis 14, dadurch gekennzeichnet, daß in zumindest einem Grundkörper (80) ein Funktionselement (89) eingespritzt, eingedrückt oder eingelegt ist.

17. Maßverkörperung nach Anspruch 15 oder Anspruch 16, dadurch gekennzeichnet, daß das Funktionselement eine Welle, Nabe oder ein Zahnrad (88) ist.

18. Verfahren zur Herstellung einer Maßverkörperung mit in Meßrichtung (X) angeordneten Magnetelementen (43, 44, 53, 63, 64, 73, 74), dadurch gekennzeichnet, daß die Maßverkörperung aus Grundkörpern (40, 50, 60, 70, 80, 90, 110, 120) zusammengefügt wird, wobei alle Magnetelemente (43, 44, 53, 63, 64, 73, 74) jedes Grundkörpers (40, 50, 60, 70, 80, 90, 110, 120) in einer einzigen gemeinsamen Richtung gleichsinnig magnetisiert sind, und daß die zusammengefügte Maßverkörperung in Meßrichtung (X) abwechselnd ein Magnetelement (43, 44, 53, 63, 64, 73, 74) eines Grundkörpers (40, 60) und eines weiteren Grundkörpers (50, 70) aufweist, wobei das Magnetfeld der Magnetelemente (43, 44, 63, 64) des einen Grundkörpers (40, 60) im zusammengefügten Zustand zu dem Magnetfeld der Magnetelemente (53, 73, 74) des anderen Grundkörpers (50, 70) entgegengesetzt gerichtet ist und daß alle Magnetelemente (13 bis 16, 23 bis 26, 33 bis 36, 43, 44, 53, 63, 64, 73, 74, 103, 104) eines Grundkörpers (10, 20, 30, 40, 50, 60, 70, 80, 90, 100, 110, 120) durch einen gemeinsamen Magnetisierungsschritt magnetisiert werden.

19. Verfahren zur Herstellung einer Maßverkörperung mit in Meßrichtung (X) angeordneten Magnetelementen (43, 44, 53, 63, 64, 73, 74), dadurch gekennzeichnet, daß die Maßverkörperung aus Grundkörpern (40, 50, 60, 70, 80, 90, 110, 120) zusammengefügt wird, wobei alle Magnetelemente (43, 44, 53, 63, 64, 73, 74) jedes Grundkörpers (40, 50, 60, 70, 80, 90, 110, 120) in einer einzigen gemeinsamen Richtung gleichsinnig magnetisiert sind, und daß die zusammengefügte Maßverkörperung in Meßrichtung (X) abwechselnd ein Magnetelement (43, 44, 53, 63, 64, 73, 74) eines Grundkörpers (40, 60) und eines weiteren Grundkörpers (50, 70) aufweist, wobei das Magnetfeld der Magnetelemente (43, 44, 63, 64) des einen Grundkörpers (40, 60) im zusammengefügten Zustand zu dem Magnetfeld der Magnetelemente (53, 73, 74) des anderen Grundkörpers (50, 70) entgegengesetzt gerichtet ist und daß die Grundkörper (10, 20, 30, 40, 50, 60, 70, 80, 90, 100, 110, 120) mittels Spritz-, Spritzgieß-, Präge-. Press- oder Sinterverfahren hergestellt werden.

20. Positionsmeßeinrichtung mit einer Maßverkörperung mit in Meßrichtung (x) angeordneten Magnetelementen (43, 44, 53, 63, 64, 73, 74), die zur Erzeugung eines positionsabhängigen Abtastsignales (A1) von einem magnetfeldempfindlichen Abtastelement abgetastet werden, dadurch gekennzeichnet, daß die Maßverkörperung aus zusammengefügten Grundkörpern (40, 50, 60, 70, 80, 90, 110, 120) besteht, wobei alle Magnetelemente (43, 44, 53, 63, 64, 73, 74) jedes Grundkörpers (40, 50, 60, 70, 80, 90, 110, 120) in einer einzigen gemeinsamen Richtung gleichsinnig magnetisiert sind, und daß die zusammengefügte Maßverkörperung in Meßrichtung (X) abwechselnd ein Magnetelement (43, 44, 53, 63, 64, 73, 74) eines Grundkörpers (40, 60) und eines weiteren Grundkörpers (50, 70) aufweist, wobei das Magnetfeld der Magnetelemente (43, 44, 63, 64) des einen Grundkörpers (40, 60) im zusammengefügten Zustand zu dem Magnetfeld der Magnetelemente (53, 73, 74) des anderen Grundkörpers (50, 70) entgegengesetzt gerichtet ist.

21. Positionsmeßeinrichtung nach Anspruch 20, dadurch gekennzeichnet, daß die Positionsmeßeinrichtung ein Multiturn-Codedrehgeber zur Messung der Absolutposition einer Antriebswelle über mehrere Umdrehungen ist, bei dem mehrere Maßverkörperungen in Form von Teilscheiben über Untersetzungsgetriebe angetrieben werden.

## Claims

1. A measuring body with magnet elements (43, 44, 53, 63, 64, 73, 74) arranged in the measuring direction (X), characterized in that the measuring body consists of base bodies (40, 50, 60, 70, 80, 90, 110, 120) joined together, wherein all magnet elements (43, 44, 53, 63, 64, 73, 74) of each base body (40, 50, 60, 70, 80, 90, 110, 120) are magnetised in the same sense in a single, common direction, and in that the joined together measuring body has alternately in the measuring direction (X) a magnet element (43, 44, 53, 63, 64, 73, 74) of one base body (40, 60) and of a further base body (50, 70), wherein the magnetic field of the magnet elements (43, 44, 63, 64) of the one base body (40, 60) is oppositely directed to the magnetic field of the magnet elements (53, 73, 74) of the other base body (50, 70).

2. A measuring body according to claim 1, characterized in that the measuring body consists of two base bodies (40, 50, 60, 70, 80, 90, 110, 120) joined together.

3. A measuring body according to claim 1 or 2, characterized in that the base bodies (40, 50, 60, 70) have at least approximately the same dimensions and there engage in the gaps of the raised magnet elements (43, 44, 63, 64) of the one base body (40, 60) the raised magnet elements (53, 73, 74) of the other base body (50, 70).

4. A measuring body according to any of claims 1 to 3, characterized in that the base bodies (40, 50, 60, 70) are joined together by adhesive.

5. A measuring body according to any of claims 1 to 4, characterized in that the magnet elements (43, 44, 53, 63, 64, 73, 74) arranged in the measuring direction (X) form an alternating magnetic field at the surface of the measuring body which is at least approximately null-symmetrical.

6. A measuring body according to claim 5, characterized in that the magnet elements (63, 64, 73, 74) are provided on a support (61, 71) with through openings (67, 77) and the magnet elements (74, 63) of the other base body (70, 60) engage in these openings (67, 77.

7. A measuring body according to claim 5, characterized in that the magnet elements are applied on a support of magnetically hard material and in that the thin webs of the support between the magnet elements are demagnetised.

8. A measuring body according to any of claims 1 to 7, characterized in that all magnet elements (13 to 16, 23 to 26, 33 to 36, 43, 44, 53, 63, 64, 73, 74, 103, 104) of a base body (10, 20, 30, 40, 50, 60, 70, 80, 90, 100, 110, 120) are magnetised parallel to the measuring direction (X) or perpendicular to the measuring direction (X) and in that the magnet elements (13 to 16, 23 to 26, 33 to 36, 43, 44, 53, 63, 64, 73, 74, 103, 104) are of raised structural form.

9. A measuring body according to claim 8, characterized in that the magnet elements (13 to 16, 23 to 26, 33 to 36, 43, 44, 53, 63, 64, 73, 74, 103, 104) have a rectangular, sinusoidal or triangular structure.

10. A measuring body according to any of claims 1 to 9, characterized in that all magnet elements (13 to 16, 23 to 26, 33 to 36) of a base body (10, 20, 30) are applied in raised form on a magnetically soft or non-magnetic support (11, 21, 31).

11. A measuring body according to any of claims 1 to 9, characterized in that all magnet elements (43, 44, 53, 63, 64, 73, 74) of a base body (40, 50, 60, 70) are applied in raised form on a support (41, 51, 61, 71), wherein the magnet elements (43, 44, 53, 63, 64, 73, 74) and the support (41, 51, 61, 71) consist of the same material and form a unitary moulded part.

12. A measuring body according to claim 10 or claim 11, characterized in that the magnet elements (13 to 16, 23 to 26, 33 to 36, 43, 44, 53, 63, 64, 73, 74, 103, 104) consist of magnetically hard material bonded by plastics material.

13. A measuring body according to any of claims 1 to 12, characterized in that magnet elements (13 to 16, 23 to 26, 33 to 36, 43, 44, 53, 63, 64, 73, 74, 103, 104) spaced from one another in the measuring direction (X) are provided in a plurality of tracks, wherein the magnet elements (13 to 16, 23 to 26, 33 to 36, 43, 44, 53, 63, 64, 73, 74, 103, 104) of the individual tracks are spaced from one another as seen perpendicular to the measuring direction (X).

14. A measuring body according to any of claims 1 to 13, characterized in that the measuring body is a graduated disc for an angle measuring device, in which the magnet elements (13 to 16, 23 to 26, 33 to 36, 43, 44, 53, 63, 64, 73, 74) are magnetised radially or axially or circularly.

15. A measuring body according to any of claims 1 to 14, characterized in that at least one base body (80) is a unitary moulded part on which is moulded at least one functional element (88).

16. A measuring body according to any of claims 1 to 14, characterized in that a functional element (89) is injection moulded, pressed or embedded in at least one base body (80).

17. A measuring body according to claim 15 or claim 16, characterized in that the functional element is a shaft, a hub or a gearwheel (88).

18. A method of making a measuring body with magnet elements (43, 44, 53, 63, 64, 73, 74) arranged in the measuring direction (X), characterized in that the measuring body is joined together from base bodies (40, 50, 60, 70, 80, 90, 110, 120), wherein all magnet elements (43, 44, 53, 63, 64, 73, 74) of each base body (40, 50, 60, 70, 80, 90, 110, 120) are magnetised in the same sense in a single common direction, and in that the joined measuring body has alternately in the measuring direction (X) a magnet element (43, 44, 53, 63, 64, 73, 74) of one base body (40, 60) and of a further base body (50, 60), wherein the magnetic field of the magnet elements (43, 44, 63, 64) of the one base body (40, 60) is directed opposite to the magnetic field of the magnet elements (53, 73, 74) of the other base body (50, 70) and in that all magnet elements (13 to 16, 23 to 26, 33 to 36, 43, 44, 53, 63, 64, 73, 74, 103, 104) of a base body (10, 20, 30, 40, 50, 60, 70, 80, 90, 100, 110, 120) are magnetised in a common magnetising step.

19. A method of making a measuring body with magnet elements (43, 44, 53, 63, 64, 73, 74) arranged in the measuring direction (X), characterized in that the measuring body is joined together from base bodies (40, 50, 60, 70, 80, 90, 110, 120), wherein all magnet elements (43, 44, 53, 63, 64, 73, 74) of each base body (40, 50, 60, 70, 80, 90, 110, 120) are magnetised in the same sense in a single common direction, and in that the joined measuring body has alternately in the measuring direction (X) a magnet element (43, 44, 53, 63, 64, 73, 74) of one base body (40, 60) and of a further base body (50, 60), wherein the magnetic field of the magnet elements (43, 44, 63, 64) of the one base body (40, 60) is directed opposite to the magnetic field of the magnet elements (53, 73, 74) of the other base body (50, 70) and in that the base bodies (10, 20, 30, 40, 50, 60, 70, 80, 90, 100, 110, 120) are made by a diecasting, injection moulding, stamping, pressing or sintering method.

20. A position measuring device with a measuring body with magnet elements (43, 44, 53, 63, 64, 73, 74) arranged in the measuring direction (X), which are sensed by a sensing element sensitive to a magnetic field to generate a position-dependent sensing signal (A1), characterized in that the measuring body consists of base bodies (40, 50, 60, 70, 80, 90, 110, 120) joined together, wherein all magnet elements (43, 44, 53, 63, 64, 73, 74) of each base body (40, 50, 60, 70, 80, 90, 110, 120) are magnetised in the same sense in a single, common direction, and in that the joined together measuring body has alternately in the measuring direction (X) a magnet element (43, 44, 53, 63, 64, 73, 74) of one base body (40, 60) and of a further base body (50, 70), wherein the magnetic field of the magnet elements (43, 44, 63, 64) of the one base body (40, 60) is oppositely directed to the magnetic field of the magnet elements (53, 73, 74) of the other base body (50, 70).

21. A position measuring device according to claim 20, characterized in that the position measuring device is a multi-turn code rotary transducer for measuring the absolute position of a drive shaft over a plurality of revolutions, in which a plurality of measuring bodies in the form of graduated discs are driven through reduction gearing.

## Revendications

1. Mesure matérialisée comportant des éléments magnétiques (43, 44, 53, 63, 64, 73, 74) qui sont disposés dans la direction de mesure (X), caractérisée par le fait que la mesure matérialisée est formée d'éléments de base (40, 50, 60, 70, 80, 90, 110, 120) assemblés, tous les éléments magnétiques (43, 44, 53, 63, 64, 73, 74) de chaque élément de base (40, 50, 60, 70, 80, 90, 110, 120) étant magnétisés dans le même sens, dans une direction unique commune, et par le fait que la mesure matérialisée assemblée présente, dans la direction de mesure (X), alternativement un élément magnétique (43, 44, 53, 63, 64, 73, 74) d'un élément de base (40, 60) et d'un autre élément de base (50, 70), le champ magnétique des éléments magnétiques (43, 44, 63, 64) de l'un des éléments de base (40, 60), à l'état assemblé, étant dirigé dans la direction opposée au champ magnétique des éléments magnétiques (53, 73, 74) de l'autre élément de base (50, 70).

2. Mesure matérialisée selon la revendication 1, caractérisée par le fait que la mesure matérialisée est formée de deux éléments de base (40, 50, 60, 70, 80, 90, 110, 120) assemblés.

3. Mesure matérialisée selon la revendication 1 ou 2, caractérisée par le fait que les corps de base (40, 50, 60, 70) ont au moins sensiblement les mêmes dimensions et que, lors de l'assemblage, les vides entre les éléments magnétiques (43, 44, 63, 64) saillants de l'un des éléments de base (40, 60) reçoivent les éléments magnétiques (53, 73, 74) saillants de l'autre élément de base (50, 70).

4. Mesure matérialisée selon l'une des revendications 1 à 3, caractérisée par le fait que les corps de base (40, 50, 60, 70) sont assemblés par collage.

5. Mesure matérialisée selon l'une des revendications 1 à 4, caractérisée par le fait que les éléments magnétiques (43, 44, 53, 54, 63, 64, 73, 74) disposés dans la direction de mesure (X) forment, à la surface de la mesure matérialisée, un champ magnétique alternatif au moins sensiblement symétrique par rapport au zéro.

6. Mesure matérialisée selon la revendication 5, caractérisée par le fait que les éléments magnétiques (63, 64, 73, 74) sont prévus sur un support (61, 71) pourvu d'évidements (67, 77) débouchants, les éléments magnétiques (74, 63) de l'autre élément de base (70, 60) pénétrant dans lesdits évidements (67, 77).

7. Mesure matérialisée selon la revendication 5, caractérisée par le fait que les éléments magnétiques sont appliqués sur un support en un alliage magnétique dur et par le fait que les fines barrettes du support, entre les éléments magnétiques, sont démagnétisées.

8. Mesure matérialisée selon l'une des revendications 1 à 7, caractérisée par le fait que tous les éléments magnétiques (13 à 16, 23 à 26, 33 à 36, 43, 44 53, 63, 64, 73, 74, 103, 104) d'un élément de base (10, 20, 30, 40, 50, 60, 70, 80, 90, 100, 110, 120) sont magnétisés parallèlement à la direction de mesure (X) ou perpendiculairement à la direction de mesure (X), et par le fait que les éléments magnétiques (13 à 16, 23 à 26, 33 à 36, 43, 44 53, 63, 64, 73, 74, 103, 104) sont pourvus d'une structuration en saillie.

9. Mesure matérialisée selon la revendication 8, caractérisée par le fait que les éléments magnétiques (13 à 16, 23 à 26, 33 à 36, 43, 53, 63, 64, 73, 74, 103, 104) présentent une structuration en rectangle, en sinusoïde ou en triangle.

10. Mesure matérialisée selon l'une des revendications 1 à 9, caractérisée par le fait que tous les éléments magnétiques (13 à 16, 23 à 26, 33 à 36) d'un élément de base (10, 20, 30) sont appliqués en saillie sur un support (11, 21, 31) magnétique doux ou non magnétique.

11. Mesure matérialisée selon l'une des revendications 1 à 9, caractérisée par le fait que tous les éléments magnétiques (43, 44 53, 63, 64, 73, 74) d'un élément de base (40, 50, 60, 70) sont appliqués en saillie sur un support (41, 51, 61, 71), les éléments magnétiques (43, 44 53, 63, 64, 73, 74) et le support (41, 51, 61, 71) étant en un même matériau et formant une pièce moulée monobloc.

12. Mesure matérialisée selon la revendication 10 ou la revendication 11, caractérisée par le fait que les éléments magnétiques (13 à 16, 23 à 26, 33 à 36, 43, 44 53, 63, 64, 73, 74, 103, 104) sont réalisés en un alliage magnétique dur à liant matière plastique.

13. Mesure matérialisée selon l'une des revendications 1 à 12, caractérisée par le fait que des éléments magnétiques (13 à 16, 23 à 26, 33 à 36, 43, 44 53, 63, 64, 73, 74, 103, 104) espacés les uns des autres dans la direction de mesure (X) sont prévus sur plusieurs pistes, les éléments magnétiques (13 à 16, 23 à 26, 33 à 36, 43, 44, 53, 63, 64, 73, 74, 103, 104) des différentes pistes étant espacés les uns par rapport aux autres vu dans la direction perpendiculaire à la direction de mesure (X).

14. Mesure matérialisée selon l'une des revendications 1 à 13, caractérisée par le fait que la mesure matérialisée est un plateau diviseur pour un dispositif de mesure d'angles dans lequel les éléments magnétiques (13 à 16, 23 à 26, 33 à 36, 43, 44, 53, 63, 64, 73, 74) sont magnétisés dans la direction radiale ou dans la direction axiale ou en cercle.

15. Mesure matérialisée selon l'une des revendications 1 à 14, caractérisée par le fait qu'au moins un élément de base (80) est un élément moulé monobloc avec au moins un élément fonctionnel (88) formé sur celui-ci.

16. Mesure matérialisée selon l'une des revendications 1 à 14, caractérisée par le fait qu'un élément fonctionnel (89) est noyé, emmanché ou serti dans au moins un élément de base (80).

17. Mesure matérialisée selon la revendication 15 ou la revendication 16, caractérisée par le fait que l'élément fonctionnel est un arbre, un moyeu ou une roue dentée (88).

18. Procédé de fabrication d'une mesure matérialisée pourvue d'éléments magnétiques (43, 44, 53, 63, 64, 73, 74) qui sont disposés dans la direction de mesure (X), caractérisé par le fait que la mesure matérialisée est assemblée à partir d'éléments de base (40, 50, 60, 70, 80, 90, 110, 120), tous les éléments magnétiques (43, 44, 53, 63, 64, 73, 74) de chaque élement de base (40, 50, 60, 70, 80, 90, 110, 120) étant magnétisés dans le même sens, dans une direction unique commune, et par le fait que la mesure matérialisée assemblée présente, dans la direction de mesure (X), alternativement un élément magnétique (43, 44, 53, 63, 64, 73, 74) d'un élément de base (40, 60) et d'un autre élément de base (50, 70), le champ magnétique des éléments magnétiques (43, 44, 63, 64) de l'un des éléments de base (40, 60), à l'état monté, étant dirigé dans le sens opposé au champ magnétique des éléments magnétiques (53, 73, 74) de l'autre élément de base (50, 70), et par le fait que tous les éléments magnétiques (13 à 16, 23 à 26, 33 à 36, 43, 44 53, 63, 64, 73, 74, 103, 104) d'un élément de base (10, 20, 30, 40, 50, 60, 70, 80, 90, 100, 110, 120) sont magnétisés par une étape de magnétisation commune.

19. Procédé de fabrication d'une mesure matérialisée comportant des éléments magnétiques (43, 44, 53, 63, 64, 73, 74) qui sontdisposés dans la direction de mesure (X), caractérisé par le fait que la mesure matérialisée est formée d'éléments de base (40, 50, 60, 70, 80, 90, 110, 120) assemblés, tous les éléments magnétiques (43, 44, 53, 63, 64, 73, 74) de chaque élément de base (40, 50, 60, 70, 80, 90, 110, 120) étant magnétisés dans le même sens, dans une direction de mesure unique commune, et par le fait que la mesure matérialisée assemblée présente, dans la direction de mesure (X), alternativement un élément magnétique (43, 44, 53, 63, 64, 73, 74) d'un élément de base (40, 60) et d'un autre élément de base (50, 70), le champ magnétique des éléments magnétiques (43, 44, 63, 64) de l'un des éléments de base (40, 60), à l'état assemblé, étant dirigé dans le sens opposé au champ magnétique des éléments magnétiques (53, 73, 74) de l'autre élément de base (50, 70), et par le fait que les éléments de base (10, 20, 30, 40, 50, 60, 70, 80, 90, 100, 110, 120) sont fabriqués par un procédé de projection, par un procédé de moulage par injection, par un procédé d'estampage, par un procédé pressage ou par un procédé de frittage.

20. Dispositif de mesure de position comportant une mesure matérialisée avec des éléments magnétiques (43, 44, 53, 63, 64, 73, 74) qui sont disposés dans la direction de mesure (X) et qui, aux fins de produire un signal de palpage (A1) dépendant de la position, sont palpés par un élément de palpage sensible au champ magnétique, caractérisé par le fait que la mesure matérialisée est formée d'éléments de base (40, 50, 60, 70, 80, 90, 110, 120) assemblés, tous les éléments magnétiques (43, 44, 53, 63, 64, 73, 74) de chaque élément de base (40, 50, 60, 70, 80, 90, 110, 120) étant magnétisés dans le même sens, dans une direction de mesure unique commune, et par le fait que la mesure matérialisée assemblée présente, dans la direction de mesure (X), alternativement un élément magnétique (43, 44, 53, 63, 64, 73, 74) d'un élément de base (40, 60) et d'un autre élément de base (50, 70), le champ magnétique des éléments magnétiques (43, 44, 63, 64) de l'un des éléments de base (40, 60), à l'état assemblé, étant dirigé dans la direction opposée au champ magnétique des éléments magnétiques (53, 73, 74) de l'autre élément de base (50, 70).

21. Dispositif de mesure de position selon la revendication 20, caractérisé par le fait que le dispositif de mesure est un codeur angulaire multi révolutions pour la mesure de la position absolue d'un arbre d'entraînement sur plusieurs tours, dans lequel plusieurs mesures matérialisées sous la forme de disques gradués sont entraînés par l'intermédiaire d'un réducteur.
